# EUROPÄISCHE PATENTSCHRIFT

(11) **EP 0 790 644 B1**
(45) Veröffentlichungstag und Bekanntmachung des Hinweises auf die Patenterteilung: **05.09.2001**
(21) Anmeldenummer: 97101426.1
(22) Anmeldetag: 30.01.1997
(51) Int. Cl.: H01L 21/70, H01L 27/01, H01C 17/28

(54) **Verfahren zum Herstellen elektrischer Schaltkreise**
Process for manufacturing electric circuits
Procédé de fabrication de circuits électriques

(30) Priorität: 16.02.1996 AT 27796
(43) Veröffentlichungstag der Anmeldung: 20.08.1997
(73) Patentinhaber: AB Mikroelektronik Gesellschaft m.b.H., 5013 Salzburg (AT)
(72) Erfinder: Wilczek, Klaus-Peter, 83404 Ainring (DE)
(74) Vertreter: Hofinger, Engelbert, Dr.Dr.

(56) Entgegenhaltungen:
- US-A- 4 788 524
- US-A- 4 796 356
- US-A- 4 899 126

## Beschreibung

Die Erfindung bezieht sich auf ein Verfahren zum Herstellen elektrischer Schaltkreise, welche durch Edelmetalle kontaktierte und über Leiterbahnen aus Kupfer elektrisch verbundene Widerstände und gegebenenfalls Dielektrika umfassen, wobei zumindest die Kontakte der Widerstände aus Edelmetall und die anschließenden Leiterbahnen aus Kupfer durch Aufbringen von Pasten und deren Sintern erzeugt werden.

Bei einem bekannten derartigen Pastensystem erfolgt zuerst das Einbrennen der Widerstände und Dielektrika und der aus einer AgPt-Legierung bestehenden Unterkreuzungen und Widerstandsanschlüsse bei 850°C an Luft. Sauerstoffzutritt ist für das Sintern von Edelmetallpasten eine wesentliche Voraussetzung. Die für die Bildung der Leiterbahnen benötigte Kupferpaste kann erst nach dem bei Luft erfolgenden Einbrennen der übrigen Komponenten aufgebracht werden, da ihre thermische Härtung unter Stickstoffatmosphäre erfolgen muß.

Bei dem einzigen bisher aus der US 4,796,356 bekannt gewordenen derartigen System, das von der Firma DuPont unter der Bezeichnung Q-SIL Niedertemperatur-Kupfer-System angeboten wird, besteht der Nachteil, daß bei einer Einbrenntemperatur von 600°C keine optimale Bindung zwischen Kupfer-Leiter und Subtrat erfolgt. Die beste Verbindung des Kupfers zu den keramischen Trägermaterialien wie Al₂O₃ oder AIN erhält man nämlich durch sogenanntes Oxidbonden: Zwischen Cu und O₂ besteht ein binäres, eutektisches System mit einem Schmelzpunkt weit über 1000°C. Jedoch auch schon bei Temperaturen von 850 - 980°C bilden sich entsprechende Spinellverbindungen. Da es sich bei diesem Verbindungsprozeß um eine interkristalline Formation handelt, wird eine äußerst hohe und thermisch stabile Haftung erzeugt. Abzugskräfte bis zu 30 N/mm² bleiben auch nach Dauertemperaturbeanspruchung von z.B. 1000 Stunden bei 150°C erhalten. Bei Einhaltung aller Trocken- und Brennvorschriften - insbesondere der Gehalt an O₂ während des Brennens - können solche Kupferbahnen auch in Schichtdicken bis 300 µm ohne weitere Veredelung mit Lot benetzt, geschweißt oder mit Aluminiumdraht gebondet werden. Somit sind die üblichen Verbindungstechniken gewährleistet.

Für die zur Herstellung des Kupferleiters dienende Paste wäre also an sich ein Einbrennen unter N₂-Atmosphäre bei 850 - 980°C in Gegenwart von 10 - 20 ppm an O₂ in der Brenn-muffel zur Erzielung optimaler Haftung erwünscht. Würde man jedoch beim bekannten System derartige Bedingungen anwenden, käme es im Verbindungsbereich von Edel-metallkontakten und Kupferleiter zur Bildung eines eutektischen binären Werkstoffsystems, welches im Fall von CuAg einen Schmelzpunkt von ca. 750°C aufweist. Dies bedeutet, daß man bei den für den Kupferleiter optimalen Brenntemperaturen von 800 - 980°C auf jeden Fall die Liquidustemperatur der Legierung erreichen würde. Beide Metalle würden aufgeschmolzen und lägen ohne Adhäsion zum Substrat als Metallkugeln vor. Eine elektrische Verbindung wäre nicht mehr gesichert.

Als Alternative bietet sich die Entwicklung von Widerstandssystemen an, welche unter N₂-Atmosphäre einbrennbar sind. Das zur Verfügung stehende Pastenspektrum auf z.B. TaN-Basis ist im Vergleich zu den in Luft einbrennbaren Systemen äußerst gering, die Wertebereiche der verfügbaren Flächenwiderstände sind limitiert. Auch weisen diese Systeme neben einem stark erhöhten Temperaturkoeffizienten des Widerstandswertes schlechte Langzeiteigenschaften, niedrige Spannungsbelastbarkeit und eingeschränkte Abgleichbarkeit mit Trimmlaser auf. Diese Widerstände sind somit aus technischer Sicht wesentlich schlechter als die "Luftsysteme" und haben dadurch nur bedingte Einsatzmöglichkeiten.

Dielektrische Systeme für Leitungskreuzungen wurden ebenfalls entwickelt. Die erzielbaren dielektrischen Konstanten von ∈ = 10 - 1000 reichen für die meisten Anwendungsfälle aus, jedoch zeigen sich Nachteile in bezug auf Haftfestigkeiten, was sich auch in der nur bedingten Lötbarkeit in der zweiten Ebene dokumentiert. Weiterhin sind die Schichten empfindlich gegen Feuchteeinwirkung, was zu verminderten Isolationswerten und im Extremfall zu Elektrodenkurzschlüssen führen kann. Die Systeme wurden nur zur Abrundung der Produktprogramme von den Pastenherstellern entwickelt, jedoch niemals optimiert.

Die Erfindung vereinigt hingegen die Vorteile der bei Luft einbrennbaren Pasten zur Herstellung der Widerstände und dielektrischen Strukturen samt ihrer Kontakte mit jenen des Einbrennens der Kupferbahnen bei hoher Temperatur, indem vorgesehen wird, daß zumindest das Sintern der Leiterbahnen aus Kupfer bei Temperaturen oberhalb von 850°C unter Stickstoffatmosphäre erfolgt und daß eine elektrisch leitende Trennschicht zwischen Edelmetallkontakten und Leiterbahn die Bildung eines binären Eutektikums aus Edelmetall/Kupfer verhindert.

Die Trennschicht wird am einfachsten durch Aufbringen einer Nickelpaste in den Grenzbereich zwischen Kupfer und Edelmetall gebildet. Die Verwendung von Nickel ist jedoch nicht kritisch, da es nur darauf ankommt, die Bildung eines binären Systems aus Kupfer und Edelmetall zu verhindern.

Die Trennschicht kann bereits vor der Wärmebehandlung der Kupferpaste aufgebracht werden. Bringt man die Verbindungspaste, welche die elektrische Verbindung und gleichzeitig die räumliche Trennung von Edelmetall und Kupfer herstellen soll, in einen Spalt zwischen Edelmetallkontakt und Kupferleiter ein, so wird die Trennschicht mit dem Kupfer-leiter beim Erhitzen unter Stickstoffatmosphäre gebrannt. Es ist jedoch auch möglich, die Verbindungspaste auf die den Edelmetallkontakt überlappende Kupferpaste aufzutragen. Das führt dazu, daß beim Erhitzen Nickel in den Verbindungsbereich von Edelmetall und Kupfer eindringt. Auf diese Weise entsteht ein ternäres System aus Edelmetall, Nickel und Kupfer und verhindert so die Bildung eines binären Eutektikums aus Kupfer und Edelmetall.

Die erfindungsgemäß vorgesehene, elektrisch leitende Trennschicht kann auch nach dem Brennen aller übrigen Schaltungsteile erfolgen, indem eine bei niedrigen Temperaturen härtende Leiterpaste in den Spalt zwischen Edelmetallkontakt und Kupferleiter aufgebracht wird. Besonders geeignet ist dabei ein Leitkleber aus in Polyimid oder Epoxid verteiltem Silber. Die Bildung eines Eutektikums Edelmetall-Kupfer wird hier nicht durch eine besondere Wahl des Materials für die Trennschicht, sondern dadurch vermieden, daß die Schichten nie auf die zur Bildung des Eutektikums notwendige Temperatur erhitzt werden.

Einzelheiten der Erfindung werden anschließend anhand der Zeichnung erläutert. In dieser ist Fig. 1 eine Draufsicht auf ein erstes Ausführungsbeispiel, Fig. 2 ein Querschnitt durch den Verbindungsbereich von Edelmetallkontakt und Leiterbahn aus Kupfer vor (Fig. 2a) und nach (Fig. 2b) der Wärmebehandlung bei einer zweiten Verfahrensvariante, Fig. 3 die Draufsicht auf eine durch Edelmetallbahnen gebildete Leiterkreuzung, welche gemäß einer dritten Verfahrensform mit Leiterbahnen aus Kupfer kontaktiert wird.

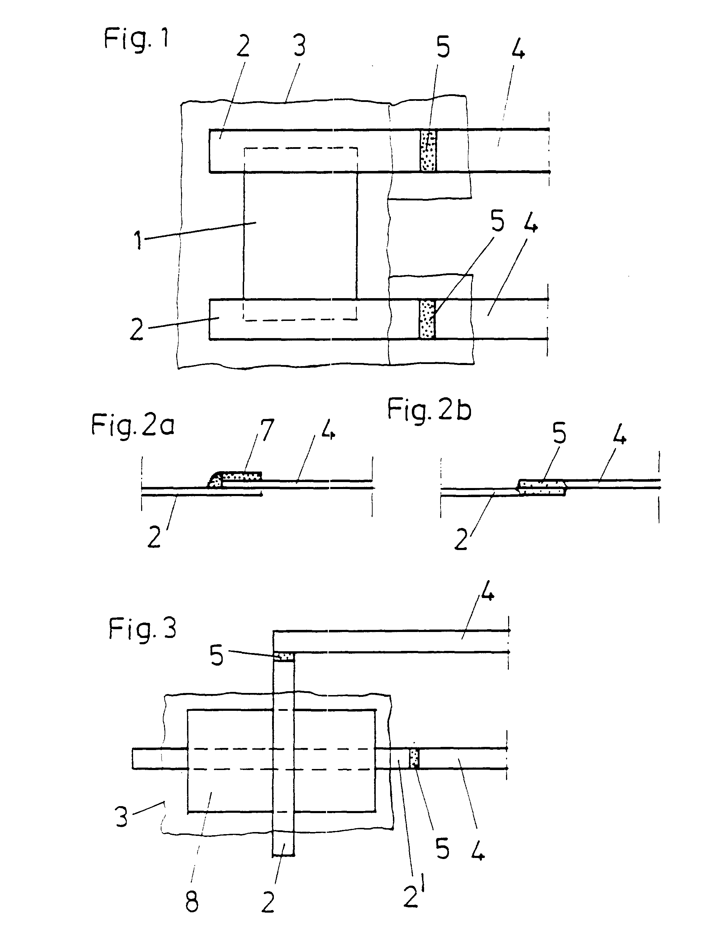

Fig. 1 zeigt einen Ausschnitt aus einem typischen elektri-schen Schaltkreis in Hybridtechnik. Gemäß dieser Technik wird ein Substrat aus Keramik nicht nur mit Verbindungsbahnen für vorgefertigte Bauteile bedruckt, mit welchen die Trägerplatte bestückt wird. Vielmehr werden zusätzlich zumindest Widerstände ebenfalls direkt auf die Trägerplatte aufgebracht.

Im vorliegenden Fall wird ein Widerstand 1 gebildet, indem eine Paste aufgetragen wird, welche bei 800 - 950°C unter Luft eingebrannt wird. Ein derartiger Widerstand aus den Grundstrukturen Pd/Ag, RuO₂ oder Pyrochlor weist nach dem Sintern hervorragende elektrische Werte, wie niedriger Temperaturkoeffizient <50 ppm/K, hohe elektrische Belastbarkeit bis 100 W/mm², extreme Langzeitstabilität der Ohmwerte +/- 1% nach 130.000 Stunden Normalbetrieb, sehr guter Abgleichbarkeit der Widerstandswerte mit YAG-Laser bis zu +/- 0,1 % Toleranz usw. auf.

Zur Kontaktierung des Widerstandes 1 dienen Kontakte 2 aus Edelmetall. Pasten zur Bildung von Leiterbahnen aus Ag, PdAg, AgPt, AgPdPt, Au, PdAu und ähnlichen Kombinationen für das Einbrennen an Luft bei 800 bis 950°C Brenntemperatur werden angeboten. Die Adhäsion der Pasten wird beim Sintervorgang durch Additive von Glas oder Oxidbildnern hergestellt. Es werden hiebei typische Haftfestigkeiten von 5 - 10 N/mm² erreicht. Alle genannten Pastensysteme sind empfindlich gegen thermische Alterung und zeigen tendenziell eine Verminderung der Haftfestigkeit nach Lagerung z.B. 1000 Stunden bei 150°C von 20 - 50 %. Gold- und silberhaltige Pasten haben zudem den Nachteil, mit den üblichen Weichlotlegierungen z.B. PbSn/PbSnAg eine eutektische Reaktion einzugehen, Silber/Gold löst sich bei Löttemperaturen von 220-250°C spontan in Zinn. Im Extremfall kommt es hiebei zum völligen Entnetzen der Paste und somit Ausfall der Schaltung durch Unterbrechungen oder Hochohmigkeit.

Die Verwendung derartiger Pasten zur Kontaktierung der Widerstände und Dielektrika ist trotz der an sich besseren Eignung von Kupfer als Leiterbahn notwendig. Nicht alle und vor allem nicht die besten Widerstände und Dielektrika sind nämlich mit Kupfer verträglich.

Zur Bildung der Hybridschaltung werden also zunächst übereinander die Pasten aufgetragen, welche zur Bildung des Widerstandes 1 und der Kontakte 2 dienen. Nach dem Einbrennen aller Drucke gemeinsam bei z.B. 850°C an Luft wird im Siebdruck die Leiterbahn 4 aus Kupfer aufgebracht und getrocknet, anschließend eine z.B. nickelhältige Verbindungspaste zur Bildung einer Trennschicht 5, welche den Spalt zwischen Kontakt 2 und Leiterbahn 4 ausfüllt. Über die Widerstände und Verbindungszonen kann später eine zusätzliche Schutzschicht 3 aus Glas oder Polymer aufgebracht werden.

Anstatt die Trennschicht 5 in einen vorgefertigten Spalt zwischen Kontakt 2 und Leiterbahn 4 einzubringen, kann man die Paste zur Bildung der Leiterbahn 4 überlappend auf den Edelmetallkontakt 2 aufdrucken, wie dies in Fig. 2a angedeutet ist. Darüber wird eine Nickelpaste 7 aufgebracht, welche im Zuge der thermischen Behandlung in die darunterliegenden Schichten eindiffundiert. Dadurch bildet sich ein ternäres System, welches die gewünschte nichteutektische Trennschicht 5 zwischen Kontakt 2 und Leiterbahn 4 bildet, wie dies Fig. 2b schematisch andeutet.

Fig. 3 zeigt die Verwendung von Edelmetallkontakten 2, 2' zur Bildung einer Leiterkreuzung, welche durch eine dielektrische Trennschicht 8 getrennt ist. Wie anhand von Fig. 1 beschrieben, erfolgt auch hier zunächst das Aufbringen der Bereiche 2, 2', 3 und 8 und deren Einbrennen an Luft. Zwischen den Kontakten 2, 2' und den nach dem Einbrennen an Luft erfolgenden Aufbringen der Kupferpasten zur Bildung der Leiterbahnen 4 verbleibt jedoch zunächst ein Spalt. Erst nach dem Brennen der Kupferpaste unter Stickstoffatmosphäre bei hoher Temperatur wird der Spalt zwischen den Kontakten 2, 2' und den Leiterbahnen 4 durch eine Trennschicht 5 ausgefüllt. Der hierzu dienende Leiter-kleber kann aus Kunststoffen, wie z.B. Epoxidharz mit darin verteiltem Silber bestehen. Die Aushärtung des Klebers erfolgt bei Raumtemperatur oder bei erhöhter Temperatur und dann so, daß das Kupfer nicht an der Oberfläche oxidiert. Man sollte 130°C nicht überschreiten. Sollte eine höhere Aushärtetemperatur notwendig sein, z.B. Silber in Polyimid, muß die Härtung unter N₂ erfolgen. Anstatt des Leiterklebers kann natürlich auch die Hochtemperaturverbindung mit einem ternären System Edelmetall/Kupfer/Nickel, wie bei den Widerständen beschrieben, angewendet werden. Die ausgehärteten Leitschichten können anschließend noch mit einer polymeren Schutzschicht 3 im Siebdruck- oder Dispensverfahren abgedeckt werden.

Mit den beschriebenen Verfahren wird es somit möglich, bisher nicht miteinander kombinierbare Dickschichttechnologien auf einem gemeinsamen Substrat zu realisieren. Dabei bleiben die physikalischen Haupteigenschaften der einzelnen Systeme voll erhalten und ergänzen sich zu einer optimalen technischen Lösung. Die hohe Haftfestigkeit und das günstige Ablegierverhalten von Kupferleiterbahnen ermöglichen den Einsatz von höherschmelzenden Lotlegierungen (220°C - 250°C) sowie die Anwendung aller gängigen Verbindungstechnologien wie Löten, Bonden und Schweißen. Deshalb werden insbesondere für die Anwendung bei erhöhten Umgebungstemperaturen, z.B. in der Automobiltechnik neue Märkte und Anwendungsmöglichkeiten gesehen.

Ein weiteres Einsatzgebiet ermöglicht die Verwendung von Leiterbahnen aus Kupfer mit selektiv höhere Schichtdicken, bis etwa von 300 µm. Dies ist bei Anwendungen mit erhöhter Verlustleistung wegen des erheblich reduzierten Flächenwiderstandes von großer technischer und kommerzieller Bedeutung.

## Patentansprüche

1. Verfahren zum Herstellen elektrischer Schaltkreise, welche durch Edelmetalle kontaktierte und über Leiterbahnen aus Kupfer elektrisch verbundene Widerstände und gegebenenfalls Dielektrika umfassen, wobei zumindest die Kontakte der Widerstände aus Edelmetall und die anschließenden Leiterbahnen aus Kupfer durch Aufbringen von Pasten und deren Sintern erzeugt werden, **dadurch gekennzeichnet**, daß zumindest das Sintern der Leiterbahnen aus Kupfer bei Temperaturen oberhalb von 850°C unter Stickstoffatmosphäre erfolgt und daß eine elektrisch leitende Trennschicht zwischen Edelmetallkontakten und Leiterbahn die Bildung eines binären Eutektikums aus Edelmetall/Kupfer verhindert.

2. Verfahren nach Anspruch 1, **dadurch gekennzeichnet**, daß eine die Trennschicht zwischen Edelmetall und Kupfer bildende Verbindungspaste vor dem sinton der Leiterbahn aus Kupfer aufgebracht wird.

3. Verfahren nach Anspruch 2, **dadurch gekennzeichnet**, daß die Verbindungspaste nach einem an Luft erfolgenden Sintern der Edelmetall-Kontakte im Anschluß an diese aufgetragen wird.

4. Verfahren nach Anspruch 2, **dadurch gekennzeichnet**, daß die zur Bildung der Leiterbahnen dienende Kupferpaste überlappend auf die Edelmetallkontakte aufgetragen und mit einer die Trennschicht bildenden Paste überlagert wird, welches unter dem Einfluß der das Sintern bewirkenden Wärmebehandlung in den Grenzbereich zwischen Edelmetall und Kupfer eindiffundiert und dadurch die Bildung des Eutektikums verhindert.

5. Verfahren nach Anspruch 3 oder 4, **dadurch gekennzeichnet**, daß die Verbindungspaste im wesentlichen aus Nickel besteht.

6. Verfahren nach Anspruch 1, **dadurch gekennzeichnet**, daß nach der Sinterung zwischen den Kontakten aus Edelmetall und den Leitern aus Kupfer ein Spalt verbleibt, der anschließend durch einen Leitkleber, der die Trennschicht bildet, verschlossen wird.

7. Verfahren nach Anspruch 6, **dadurch gekennzeichnet**, daß der Leitkleber im wesentlichen aus in Polyimid verteiltem Silber besteht.

## Claims

1. A process for producing electrical circuits which include, contacted by noble metals and electrically connected by way of conductor tracks of copper, resistors and possibly dielectrics, wherein at least the contacts of the resistors of noble metal and the connecting conductor tracks of copper are produced by applying pastes and sintering thereof, **characterised in that** at least the operation of sintering the conductor tracks of copper is effected at temperatures above 850°C in a nitrogen atmosphere and that an electrically conductive separating layer between noble metal contacts and conductor track prevents the formation of a binary eutectic of noble metal/copper.

2. A process according to claim 1 **characterised in that** a connecting paste forming the separating layer between noble metal and copper is applied prior to the operation of sintering the conductor track of copper.

3. A process according to claim 2 **characterised in that** the connecting paste is applied after an operation of sintering the noble metal contacts which is effected in air, subsequently thereto.

4. A process according to claim 2 **characterised in that** the copper paste serving to form the conductor tracks is applied in overlapping relationship to the noble metal contacts and is overlaid with a paste forming the separating layer, which under the influence of the heat treatment causing sintering diffuses into the boundary region between noble metal and copper and thereby prevents the formation of the eutectic.

5. A process according to claim 3 or claim 4 **characterised in that** the connecting paste substantially comprises nickel.

6. A process according to claim 1 **characterised in that** after the sintering operation a gap remains between the contacts of noble metal and the conductors of copper, the gap then being closed by a conductive adhesive which forms the separating layer.

7. A process according to claim 6 **characterised in that** the conductive adhesive substantially comprises silver which is distributed in polyimide.

## Revendications

1. Procédé de fabrication de circuits électriques comprenant des résistances, mises en contact à l'aide de métaux nobles, et reliées électriquement par l'intermédiaire de pistes conductrices en cuivre et comprenant, le cas échéant, des diélectriques, au moins les contacts des résistances en métal noble et les pistes conductrices raccordées en cuivre étant générées par application de pâtes et frittage de celles-ci, **caractérisé en ce qu**'au moins le frittage des pistes conductrices en cuivre s'effectue à des températures supérieures à 850° C, sous une atmosphère d'azote, et en ce qu'une couche séparatrice, conductrice de l'électricité, placée entre des contacts en métal noble et la piste conductrice, empêche toute formation d'un eutectique binaire en métal noble/cuivre.

2. Procédé selon la revendication 1, **caractérisé en ce qu**'une pâte de liaison, formant la couche séparatrice entre le métal noble et le cuivre, est appliquée avant le frittage de la piste conductrice en cuivre.

3. Procédé selon la revendication 2, **caractérisé en ce que** la pâte de liaison est appliquée après frittage, pratiqué à l'air, des contacts en métal noble, en raccordement à ceux-ci.

4. Procédé selon la revendication 2, **caractérisé en ce que** la pâte de cuivre servant à former les pistes conductrices est appliquée en chevauchement sur les contacts en métal noble et recouverte d'une pâte formant la couche séparatrice, qui, sous l'influence du traitement thermique provoquant le frittage, diffuse en profondeur, dans la zone limite entre le métal noble et le cuivre, et empêche de ce fait la formation de l'eutectique.

5. Procédé selon la revendication 3 ou 4, **caractérisé en ce que** la pâte de liaison est essentiellement constituée de nickel.

6. Procédé selon la revendication 1, **caractérisé en ce qu**'après le frittage, entre les contacts formés en métal noble et les conducteurs en cuivre subsiste un intervalle qui est ensuite fermé au moyen d'un adhésif conducteur, qui forme la couche séparatrice.

7. Procédé selon la revendication 6, **caractérisé en ce que** l'adhésif conducteur est essentiellement constitué d'argent, réparti dans un polyimide.
